Europäisches Patentamt

European Patent Office

Office européen des brevets

(19)

(11) Veröffentlichungsnummer: **0 104 537**
**A2**

(12) **EUROPÄISCHE PATENTANMELDUNG**

(21) Anmeldenummer: 83109023.8

(22) Anmeldetag: 13.09.83

(51) Int. Cl.³: **G 03 F 7/26**

(30) Priorität: 23.09.82 US 422106

(43) Veröffentlichungstag der Anmeldung:
04.04.84 Patentblatt 84/14

(84) Benannte Vertragsstaaten:
DE FR GB

(71) Anmelder: AMERICAN HOECHST CORPORATION
Route 202-206 North
Somerville, N.J. 08876(US)

(72) Erfinder: Hsieh, Shane
4, Linvale Lane
Bridgewater New Jersey 08807(US)

(72) Erfinder: Simonsen, Richard
R.D. No. 1, Sunrise Circle
Clinton New Jersey 08809(US)

(74) Vertreter: Euler, Kurt Emil, Dr. et al,
KALLE Niederlassung der Hoechst AG Rheingaustrasse
190 Postfach 3540
D-6200 Wiesbaden 1(DE)

(54) Entwickler und Verfahren zum Entwickeln für bestrahlte negativ-arbeitende Reproduktionsschichten.

(57) Der wäßrige Entwickler für bestrahlte strahlungsempfindliche negativ-arbeitende Reproduktionsschichten enthält Wasser und ein wasserlösliches Salz des Schwefelsäuremonoesters des Dodecanols (Laurylsulfat). Die Reproduktionsschicht enthält insbesondere kein organisches Bindemittel. Der Entwickler ist mit einer anorganischen Säure (z. B. $H_3PO_4$) auf einen pH-Wert von 0 bis 4 eingestellt. Die Erfindung betrifft auch ein Verfahren zum Entwickeln der Schichten mit diesem Entwickler.

EP 0 104 537 A2

AMERICAN HOECHST CORPORATION
Somerville, N.J. 08876/USA

82/K 093        - 1 -        05.08.1983
                   WLK-Dr.I.-gt

Entwickler und Verfahren zum Entwickeln für bestrahlte negativ-arbeitende Reproduktionsschichten

Die Erfindung betrifft einen Entwickler, der zum Entwickeln von negativ-arbeitenden bestrahlten (belichteten) Reproduktionsschichten geeignet ist, die insbesondere kein organisches Bindemittel enthalten.

Strahlungs(licht)empfindliche Reproduktionsschichten werden beispielsweise bei der Herstellung von Offsetdruckformen oder von Photoresists (beides im weiteren Kopiermaterialien genannt) verwendet, d. h. sie werden im allgemeinen vom Verbraucher oder vom industriellen Hersteller auf einen Schichtträger aufgebracht. Als Schichtträger in diesen Kopiermaterialien werden Metalle wie Zink, Magnesium, Chrom, Kupfer, Messing, Stahl, Silicium, Aluminium oder Kombinationen dieser Metalle, Kunststoffolien, Papier oder ähnliche Materialien eingesetzt. Diese Schichtträger können ohne eine modifizierende Vorbehandlung, bevorzugt aber nach Durchführung einer Oberflächenmodifizierung wie einer mechanischen, chemischen und/oder elektrochemischen Aufrauhung, einer Oxidation und/oder einer Behandlung mit Hydrophilierungsmitteln (z. B. bei Trägern für Offsetdruckplatten) mit der strahlungsempfindlichen Reproduktionsschicht beschichtet werden. Die üblichen Reproduktionsschichten enthalten neben mindestens einer strahlungsempfindlichen Verbindung meist noch ein organisches Bindemittel (Harze o. ä.) und gegebenenfalls auch

AMERICAN HOECHST CORPORATION
Somerville, N.J. 08876/USA

- 2 -

noch Weichmacher, Pigmente, Farbstoffe, Netzmittel, Sensibilisatoren, Haftvermittler, Indikatoren und andere übliche Hilfsmittel. In letzter Zeit sind aber auch bindemittelfreie Reproduktionsschichten in der Praxis anzutreffen. Die Reproduktionsschichten werden nach ihrer Belichtung entwickelt, um aus ihnen ein Bild zu erzeugen, beispielsweise wird so eine Druckform oder ein Photoresist erhalten.

Ein Entwickler für negativ-arbeitende Reproduktionsschichten muß die nicht von elektromagnetischer Strahlung (z. B. Licht) getroffenen Schichtteile (die späteren Nichtbildstellen) aus der belichteten Schicht herauslösen können, ohne dabei die von der Strahlung getroffenen Teile (die späteren Bildstellen) der Schicht wesentlich zu beeinflussen. In der als ein repräsentatives Beispiel zu nennenden DE-A 20 65 732 (= US-A 3 867 147) werden als geeignete Entwickler beispielsweise aufgeführt: Wasser, Wasser/organische Lösemittel-Gemische, wäßrige Salzlösungen, wäßrige Säurelösungen, wäßrig-alkalische Lösungen und unverdünnte organische Lösemittel, denen gegebenenfalls Tenside und/oder Hydrophilierungsmittel zugesetzt werden können. Die in den dortigen Beispielen hauptsächlich eingesetzten Entwickler enthalten Wasser, Na-laurylsulfat, Na-sulfat, Weinsäure und gegebenenfalls Benzylalkohol; andere Entwickler enthalten oder bestehen aus Isopropanol, n-Propanol, n-Propylacetat, Polyacrylsäure, 1,1,1-Trichlorethan, Aceton oder Ethylenglykolmonomethylether. Die am besten wirksamen Entwickler für solche negativ-

AMERICAN HOECHST CORPORATION
Somerville, N.J. 08876/USA

- 3 -

arbeitenden Reproduktionsschichten enthalten aber bisher in der Regel bestimmte Tenside, so daß insbesondere bei einer maschinellen Entwicklung ein Aufschäumen des Entwicklers auftritt.

Neben den bereits erwähnten Entwicklerkomponenten sind auch noch folgende aus dem Stand der Technik bekanntgeworden:

In der DE-A 30 36 077 werden als für Diazoniumsalzpolykondensate und bestimmte Bindemittel (Polymere mit seitenständigen Alkenylsulfonyl- oder Cycloalkenylsulfonylurethangruppen) enthaltende Reproduktionsschichten geeignete Entwickler wäßrig-alkalische Lösungen mit einem pH-Wert von 8 bis 14 (vorzugsweise 10 bis 13) genannt, die Puffersalze wie Alkaliphosphate, -silikate, -borate, -carbonate, -acetate oder -benzoate enthalten können. Als mögliche weitere Bestandteile werden anionische Netzmittel (z. B. Natriumlaurylsulfat) und wasserlösliche Polymere genannt.

In der EP-A 0 056 138 (= US-A 4 395 480) werden wäßrige Entwickler, insbesondere für bindemittelfreie Reproduktionsschichten beschrieben, die neben einem Alkanoat von $C_8$ bis $C_{13}$ noch ein schwachschäumendes nichtionogenes Tensid enthalten. Alkanoate bis zu $C_9$ enthalten die Entwickler gemäß der EP-A 0 033 232 (=US-A 4 350 756).

Die bekannten im Regelfalle mehr oder weniger alkalischen Entwickler sind zwar für manche Anwendungen geeignet

AMERICAN HOECHST CORPORATION
Somerville, N.J. 08876/USA

- 4 -

und lassen sich beispielsweise auch bei einer Küvettenentwicklung oftmals praxisgerecht einsetzen, sie weisen jedoch bei einigen der bekannten negativ-arbeitenden Reproduktionsschichten Schwierigkeiten auf; dies gilt insbesondere bei ihrem Einsatz in den heute sehr verbreiteten Entwicklungsmaschinen, in denen beispielsweise Schaum- und/oder Korrosionsprobleme auftreten können. Es treten hin und wieder auch Probleme in der Farbannahme der Bildstellen bzw. im Freilaufen der Druckformen beim Drucken auf.

Aufgabe der vorliegenden Erfindung ist es, einen wäßrigen Entwickler für negativ-arbeitende Reproduktionsschichten vorzuschlagen, der keine Zusätze von organischen Lösemitteln benötigt und möglichst nicht die übrigen, vorher dargestellten Nachteile aufweist.

Die Erfindung geht aus von einem wäßrigen Entwickler für bestrahlte strahlungsempfindliche negativ-arbeitende, insbesondere kein organisches Bindemittel enthaltende Reproduktionsschichten auf der Basis von Wasser und einem wasserlöslichen Salz des Schwefelsäuremonoesters des Dodecanols (Laurylsulfat). Der erfindungsgemäße Entwickler ist dann dadurch gekennzeichnet, daß der Entwickler mit einer anorganischen Säure auf einen pH-Wert von 0 bis 4 eingestellt ist.

Eine weitere Lösung der gestellten Aufgabe ist ein Verfahren zum Entwickeln von negativ-arbeitenden Reproduktionsschichten, bei dem die bestrahlte, insbesondere

AMERICAN HOECHST CORPORATION
Somerville, N.J. 08876/USA

- 5 -

kein organisches Bindemittel enthaltende Reproduktionsschicht mit einem Entwickler mit den angegebenen Komponenten behandelt wird. Dabei werden die nicht von der
Strahlung getroffenen Stellen der Reproduktionsschicht
(z. B. die beim späteren Drucken benötigten Nichtbildstellen) in der Regel durch Auflösen entfernt.

In einer bevorzugten Ausführungsform ist das Salz des
Schwefelsäuremonoesters des Dodecanols ein Natrium-,
Magnesium- oder Ammoniumsalz, wie es beispielsweise
als $^{(R)}$ Sulfatex 110 $^{(R)}$ Sipon ES oder $^{(R)}$ Sipon LM von
Alcolac Inc., $^{(R)}$ Standapol A von Henkel Corp. oder
$^{(R)}$ Polystep B-25 von Stepan Chemical Co. vertrieben
wird. Die anorganische Säure ist insbesondere Phosphor-,
Salz- oder Schwefelsäure, wobei Phosphorsäure besonders
bevorzugt wird. Der Entwickler kann auch noch zusätzlich
Salze wie Natrium-, Lithium-, Magnesium- oder Ammoniumsulfate, -nitrate, -chloride, -phosphate oder -hydroxide
enthalten; insbesondere sind dies $MgSO_4$, $Mg(NO_3)_2$,
$Li_2SO_4$, $LiNO_3$, $LiCl$, $LiOH$, $(NH_4)_2SO_4$, $NH_4NO_3$, $NH_4Cl$,
$NaCl$, $NaH_2PO_4$ und $Na_2HPO_4$. Die einzusetzenden Komponentenmengen bewegen sich - bezogen auf die wäßrige
Entwicklerlösung - im allgemeinen im Bereich von 1 bis
30 Gew.-%, insbesondere 1 bis 10 Gew.-% und bevorzugt
2 bis 5 Gew.-% für das Salz des Schwefelsäuremonoesters
des Dodecanols, im Bereich von 0,5 bis 10 Gew.-%, insbesondere 1 bis 6 Gew.-% und bevorzugt 2 bis 4 Gew.-% für
die anorganische Säure und im Bereich von 0,1 bis
20 Gew.-%, insbesondere 1 bis 10 Gew.-% und bevorzugt 2
bis 5 Gew.-% für das gegebenenfalls zusätzlich vorhandene
Salz.

Die erfindungsgemäßen Entwickler sind dazu geeignet, die angegebenen Reproduktionsschichten sauber aufzuentwickeln, ohne daß es zu einem Angriff oder einer Unterwanderung der Bildstellen kommmt. Außerdem treten keine größeren Umweltprobleme, z. B. durch destillative Aufarbeitung von organischen Lösemittelanteilen auf, und die erfindungsgemäßen Entwickler lassen sich zumindest ohne größeres Schaumauftreten auch in automatischen Verarbeitungsmaschinen einsetzen. Darüber hinaus laufen die so entwickelten Platten als Druckform schneller frei (siehe Beispiele).

Die zu entwickelnde Reproduktionsschicht liegt insbesondere als Teil (strahlungsempfindliche Schicht) einer Offsetdruckplatte oder als auf ein Trägermaterial aufgebrachter Resist (Photoresistschicht) vor. Als Trägermaterialien kommen beispielsweise solche auf der Basis von Zink, Chrom, Magnesium, Kupfer, Messing, Stahl, Silicium, Aluminium oder Kombinationen dieser Metalle in Frage oder auch Kunststoffolien, Papier oder damit vergleichbare Materialien. Diese können ohne eine spezielle modifizierende Vorbehandlung mit einer geeigneten Reproduktionsschicht versehen werden, bevorzugt wird diese Beschichtung jedoch erst nach einer Oberflächenmodifizierung wie einer mechanischen, chemischen oder elektrochemischen Aufrauhung, einer Oxidation und/ oder einer Behandlung mit Hydrophilierungsmitteln (insbesondere bei Trägern für Offsetdruckplatten) durchgeführt. Zu den besonders geeigneten Substraten zur Herstellung von Offsetdruckplatten zählen solche aus Aluminium oder einer seiner Legierungen.

AMERICAN HOECHST CORPORATION
Somerville, N.J. 08876/USA

- 7 -

Die in der Praxis sehr häufig anzutreffenden Aluminiumträgermaterialien für Druckplatten werden im allgemeinen vor Aufbringen der lichtempfindlichen Schicht noch mechanisch (z. B. durch Bürsten und/oder mit Schleifmittel-Behandlungen), chemisch (z. B. durch Ätzmittel) und/oder elektrochemisch (z. B. durch Wechselstrombehandlung in wäßrigen HCl- oder $HNO_3$-Lösungen) aufgerauht.

Nach dem bevorzugt angewendeten elektrochemischen Aufrauhverfahren schließt sich dann in einer weiteren, gegebenenfalls anzuwendenden Verfahrensstufe eine anodische Oxidation des Aluminiums an, um beispielsweise die Abriebs- und Haftungseigenschaften der Oberfläche des Trägermaterials zu verbessern. Zur anodischen Oxidation können die üblichen Elektrolyte wie $H_2SO_4$, $H_3PO_4$, $H_2C_2O_4$, Amidosulfonsäure, Sulfobernsteinsäure, Sulfo-salicylsäure oder deren Mischungen eingesetzt werden.

Der Stufe einer anodischen Oxidation des Druckplatten-Trägermaterials aus Aluminium können auch eine oder mehrere Nachbehandlungsstufen nachgestellt werden. Dabei wird unter Nachbehandeln insbesondere eine hydrophilierende chemische oder elektrochemische Behandlung der Aluminiumoxidschicht verstanden, beispielsweise eine Tauchbehandlung des Materials in einer wäßrigen Polyvinylphosphonsäure-Lösung nach der DE-C 16 21 478 (= GB-A 1 230 447), eine Tauchbehandlung in einer wäßrigen Alkalisilikat-Lösung nach der DE-B 14 71 707 (= US-A 3 181 461) oder eine elektrochemische Behandlung (Anodisierung) in einer wäßrigen Alkalisilikat-

AMERICAN HOECHST CORPORATION
Somerville, N.J. 08876/USA

- 8 -

Lösung nach der DE-A 25 32 769 (= US-A 3 902 976).
Diese Nachbehandlungsstufen dienen insbesondere dazu,
die bereits für viele Anwendungsgebiete ausreichende
Hydrophilie der Aluminiumoxidschicht noch zusätzlich zu
steigern, wobei die übrigen bekannten Eigenschaften
dieser Schicht mindestens erhalten bleiben.

Als negativ-arbeitende lichtempfindliche Reproduktionsschichten sind grundsätzlich alle Schichten geeignet,
die nach dem Belichten, mit einer nachfolgenden Entwicklung und gegebenenfalls Fixierung eine bildmäßige
Fläche liefern, von der gedruckt werden kann und/oder
die ein Reliefbild einer Vorlage darstellt. Sie werden
entweder beim Hersteller von vorsensibilisierten
Druckplatten oder von sogenannten Trockenresists oder
direkt vom Verbraucher auf eines der üblichen Trägermaterialien aufgebracht. Außer den lichtempfindlichen
Substanzen können diese Schichten selbstverständlich
noch andere Bestandteile wie z. B. Harze, Farbstoffe
oder Weichmacher enthalten. Insbesondere kommen als
strahlungsempfindliche Verbindungen solche in Betracht,
die in der eingangs bereits zitierten DE-A 2 065 732 und
EP-A 0 056 138 beschrieben werden.

In den nachfolgenden Beispielen wird von einer
Druckplatte ausgegangen, die auf einem elektrochemisch
aufgerauhten, anodisch oxidierten und zusätzlich
hydrophilierten Trägermaterial aus Aluminium eine
lichtempfindliche Beschichtung ohne spezielles Bindemittel mit einem Polykondensationsprodukt aus

AMERICAN HOECHST CORPORATION
Somerville, N.J. 08876/USA

- 9 -

4,4'-Bis-methoxymethyl-diphenylether und 3-Methoxy-
diphenylamin-4-diazoniumsulfat und einen blauen Farbstoff
aufweist.

Beispiele 1 bis 3 und Vergleichsbeispiele V 1 bis V 3

Wäßrige Entwickler werden aus Natriumlaurylsulfat,
$MgSO_4$ und Wasser hergestellt, die eine Hälfte der
jeweiligen Lösung wird auf einen pH-Wert zwischen 0 und 4
mit $H_3PO_4$ eingestellt und die andere Hälfte auf ihrem
über 4 liegenden pH-Wert belassen.

| Beispiel | Gehalt (Gew.-%) der Lösung an | | pH-Wert | Entwicklungs-geschwindigkeit |
| --- | --- | --- | --- | --- |
| | Natriumlauryl-sulfat | $MgSO_4$ | | |
| V 1 | 3 | 1 | > 4 | sehr langsam |
| 1 | 3 | 1 | < 1 | langsam bis ausreichend |
| V 2 | 3 | 2 | > 4 | sehr langsam |
| 2 | 3 | 2 | < 1 | langsam bis ausreichend |
| V 3 | 3 | 3 | > 4 | sehr langsam |
| 3 | 3 | 3 | < 1 | ausreichend |

Die oben erwähnten Druckplatten werden vor der Entwicklung so belichtet, daß ein 21-stufiger Stauffer-
Stufenkeil 6 vollständig gedeckte Keilstufen zeigt. Bei
allen Vergleichsbeispielen tritt in den Nichtbild-

AMERICAN HOECHST CORPORATION
Somerville, N.J. 08876/USA

- 10 -

bereichen beim Drucken Ton auf, nicht jedoch bei den
erfindungsgemäß entwickelten Platten.

Beispiel 4 und Vergleichsbeispiel V 4

Ein wäßriger Entwickler wird aus 5 Gew.-% Natriumlaurylsulfat und 3 Gew.-% $Mg(NO_3)_2$ hergestellt und wie in den
Beispielen 1 bis 3 entwickelt. Nach dem Abspülen mit
Wasser wird die Druckplatte mit einer Dextrin enthaltenden Konservierungslösung behandelt und als Druckform in
eine Druckmaschine eingespannt und - ohne vorherige
Benetzung mit Wasser - von ihr bis zum Freilaufen der
Druckform gedruckt. Bis zum Freilaufen der Druckform werden 25 Blätter verbraucht, bei Einsatz eines alkalischen
Nonanoat, Phosphat und ein schwachschäumendes nichtionogenes Tensid auf der Basis von Propylen-/Ethylenoxid
enthaltenden Entwicklers etwa 180 Blätter.

Beispiel 5 und Vergleichsbeispiel V 5

Es wird nach den Angaben des Beispiels 4 und des
Vergleichsbeispiels V 4 verfahren, aber die Druckform
vor dem Drucken mit Wasser benetzt; dabei werden 25 bzw.
30 Blätter (V 5) verbraucht.

Beispiel 6 und Vergleichsbeispiel V 6

Es wird nach den Angaben des Beispiels 5 und des
Vergleichsbeispiels V 5 verfahren, aber eine kleine Menge
des Entwicklers auf die konservierte Druckform gebracht

AMERICAN HOECHST CORPORATION
Somerville, N.J. 08876/USA

- 11 -

und dort trocknen gelassen; dabei werden 15 bzw. 60 bis 70 Blätter (V 6) verbraucht.

Beispiel 7 und Vergleichsbeispiel V 7

Es wird nach den Angaben des Beispiels 4 und des Vergleichsbeispiels V 4 verfahren, aber eine kleine Menge des Entwicklers auf die konservierte Druckform gebracht und dort trocknen gelassen; dabei werden 13 bzw. mehr als 200 Blätter (V 7) verbraucht.

AMERICAN HOECHST CORPORATION
Somerville, N.J. 08876/USA

- 12 -                    05.08.1983
                         WLK-Dr.I.-gt

Patentansprüche

1. Wäßriger Entwickler für bestrahlte strahlungsempfindliche negativ-arbeitende, insbesondere kein organisches Bindemittel enthaltende Reproduktionsschichten
auf der Basis von Wasser und einem wasserlöslichen
Salz des Schwefelsäuremonoesters des Dodecanols
(Laurylsulfat), dadurch gekennzeichnet, daß der Entwickler mit einer anorganischen Säure auf einen
pH-Wert von 0 bis 4 eingestellt ist.

2. Entwickler nach Anspruch 1, dadurch gekennzeichnet,
daß das wasserlösliche Salz ein Natrium-, Magnesium-
oder Ammoniumkation aufweist.

3. Entwickler nach Anspruch 1 oder 2, dadurch gekennzeichnet, daß die anorganische Säure Phosphor-, Salz-
und/oder Schwefelsäure ist.

4. Entwickler nach einem der Ansprüche 1 bis 3, dadurch
gekennzeichnet, daß das wasserlösliche Salz in einem
Anteil von 1 bis 30 Gew.-% im Entwickler vorhanden ist.

5. Entwickler nach einem der Ansprüche 1 bis 4, dadurch
gekennzeichnet, daß der Entwickler zusätzlich mindestens 1 bis 20 Gew.-% eines Salzes aus der Gruppe
der Natrium-, Lithium-, Magnesium- oder
Ammoniumsulfate, -nitrate, -chloride, -phosphate oder
-hydroxide enthält.

0104537

AMERICAN HOECHST CORPORATION
Somerville, N.J. 08876/USA

— 13 —

6. Verfahren zum Entwickeln von negativ-arbeitenden Reproduktionsschichten, bei dem die bestrahlte, insbesondere kein organisches Bindemittel enthaltende
Reproduktionsschicht mit einem wäßrigen Entwickler auf
der Basis von Wasser und einem wasserlöslichen Salz
des Schwefelsäuremonoesters des Dodecanols behandelt
wird, dadurch gekennzeichnet, daß der Entwickler vor
der Behandlung mit einer anorganischen Säure auf einen
pH-Wert von 0 bis 4 eingestellt wird.